# EUROPEAN PATENT APPLICATION

(11) **EP 4 651 174 A2**
(43) Date of publication of application: **19.11.2025**
(21) Application number: 25176932.9
(22) Date of filing: 16.05.2025
(51) Int. Cl.: H01J 37/147, H01J 37/26, H01J 37/28

(54) **SCANNING DEFLECTOR**

(30) Priority: 17.05.2024 US 202418667077
(71) Applicant: FEI COMPANY, Hillsboro, OR 97124 (US)
(72) Inventor: RUSNACKO, Juraj, Lucivna (SK); SEDA, Bohuslav, Blansko (CZ); VASINA, Radovan, Brno (CZ); STOPKA, Jan, Brno (CZ); SEARS, Chris, Happy Valley (US)
(74) Representative: Boult Wade Tennant LLP

(57) **Abstract**

The charged beam particle system including a first electron detector, a second electron detector, and a first scanning deflector positioned between the first electron detector and the second electron detector, where the first scanning deflector includes a deflector interior surface including a frustoconical shape.

## Description

### BACKGROUND

Charged particle beam systems are used in a variety of applications including the manufacturing, repair, and inspection of miniature devices, such as integrated circuits, magnetic recording heads, and photolithography masks. One type of charged particle beam system may include an electron microscope. Electron microscopes are used as imaging tools by focusing an electron beam of a sufficient size from an electron emitter onto a focused location on a sample and then detecting the signal electrons (or photons) that are emitted from the sample at the focused location to generate a high-resolution image of the sample.

### BRIEF SUMMARY

One aspect of the disclosure provides for a charged beam particle system including a first electron detector, a second electron detector, and a first scanning deflector positioned between the first electron detector and the second electron detector, where the first scanning deflector includes a deflector interior surface including a frustoconical shape.

Implementations may additionally include one or more of the following features. The charged beam particle system may include a second scanning deflector, where the second electron detector is positioned between the second scanning deflector and the first scanning deflector. The first scanning deflector may include a first end oriented toward the first electron detector and a second end oriented toward the second electron detector, and the first end may have a first diameter and the second end has a second diameter different than the first diameter. The second diameter may be greater than the first diameter. The deflector interior surface may define a first slope from the first end to the second end, and the drift section may include a drift interior surface defining a second slope from the second end to the second electron detector that is substantially the same as the first slope. The system may include a beam column, where the first electron detector, the second electron detector, and the first scanning deflector may be in the beam column. The beam column may include a booster tube, and the first scanning deflector, the first electron detector, and the second electron detector are positioned in, or around a length of, the booster tube. The charged beam particle system may include a sample chamber including a sample holder having a sample bias. The first electron detector may be a backscatter electron detector configured to measure a first current of backscatter electrons and the second electron detector is a secondary electron detector configured to measure a second current of secondary electrons.

Another aspect of the disclosure provides for a charged beam particle system including a first electron detector, a second electron detector, and a first scanning deflector positioned between the first electron detector and the second electron detector. The first scanning deflector includes a first end having a first diameter and a second end having a second diameter greater than the first diameter, and the first end oriented is toward the first electron detector and the second end is oriented toward the second electron detector.

Implementations may include one or more of the following features. The first scanning deflector may include a deflector interior surface including a frustoconical shape. The system may include a second electron detector, where the second electron detector may be positioned between the second scanning deflector and the first scanning deflector. The system may include a drift section extending from the second end to the second electron detector, where a deflector interior surface of the first scanning deflector may define a first slope from the first end to the second end, and the drift section may include a drift interior surface defining a second slope from the second end to the second electron detector that is substantially the same as the first slope. The system may include a beam column, where the first electron detector, the second electron detector, and the first scanning deflector are in the beam column. The beam column may include a booster tube, and the first scanning deflector, the first electron detector, and the second electron detector are positioned in, or around a length of, the booster tube. The charged beam particle system may include a sample chamber including a sample holder having a sample bias. The first electron detector may be a backscatter electron detector configured to measure a first current of backscatter electrons and the second electron detector is a secondary electron detector configured to measure a second current of secondary electrons.

Another aspect of the disclosure provides for a method of using a charged beam particle emitting an electron beam from an electron source, through a beam column, to a sample holder in a sample chamber. The beam column includes a first electron detector, a second electron detector, and a first scanning deflector positioned between the first electron detector and the second electron detector, where the first scanning deflector includes a deflector interior surface including a frustoconical shape. The method also includes detecting, with the first electron detector, a first portion of signal electrons emitted from the sample chamber, and detecting, with the second electron detector, a second portion of the signal electrons emitted from the sample chamber. The method also includes generating an image based on the first and second portions of the electrons.

Implementations may include one or more of the following features. The method where the first electron detector may be a backscatter electron detector configured to measure a first current of backscatter electrons and the second electron detector is a secondary electron detector configured to measure a second current of secondary electrons. The beam column may includes= a second scanning deflector, and the second electron detector is positioned between the second scanning deflector and the first scanning deflector.

Further aspects of the invention are set out in the following numbered clauses:
Clause 1. A charged beam particle system comprising:
   a first electron detector;
   a second electron detector; and
   a first scanning deflector positioned between the first electron detector and the second electron detector, wherein:
   the first scanning deflector includes a first end having a first diameter and a second end having a second diameter greater than the first diameter; and
   the first end is oriented toward the first electron detector and the second end is oriented toward the second electron detector.
Clause 2. The charged beam particle system of claim 1, wherein the first scanning deflector includes a deflector interior surface including a frustoconical shape.
Clause 3. The charged beam particle system of clause 1 or clause 2, further comprising a second scanning deflector, wherein the second electron detector is positioned between the second scanning deflector and the first scanning deflector.
Clause 4. The charged beam particle system of clause 3,
   further comprising a drift section extending from the second end to the second electron detector,
   wherein:
      a deflector interior surface of the first scanning deflector defines a first slope from the first end to the second end; and
      the drift section includes a drift interior surface defining a second slope from the second end to the second electron detector that is substantially the same as the first slope.
Clause 5. The charged beam particle system of any one of the previous clauses, further comprising a beam column, wherein the first electron detector, the second electron detector, and the first scanning deflector are in the beam column.
Clause 6. The charged beam particle system of clause 5, wherein:
   the beam column includes a booster tube; and
   the first scanning deflector, the first electron detector, and the second electron detector are positioned in, or around a length, of the booster tube.
Clause 7. The charged beam particle system of clause 5, further comprising a sample chamber including a sample holder having a sample bias.
Clause 8. The charged beam particle system of any one of the preceding clauses, wherein the first electron detector is a backscatter electron detector configured to measure a first current of backscatter electrons and the second electron detector is a secondary electron detector configured to measure a second current of secondary electrons.

### BRIEF DESCRIPTION OF THE DRAWINGS

A further understanding of the nature and advantages of various embodiments may be realized by reference to the following figures. In the appended figures, similar components or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.
FIG. 1 depicts a simplified cross-sectional view of an example charged beam particle system.
FIG. 2A depicts a simplified cross-sectional view of an example charged beam particle system according to an embodiment of the disclosure.
FIG. 2B depicts the charged beam particle system of FIG. 2A measuring signal electrons emitted from a sample according to an embodiment of the disclosure.
FIG. 3 depicts a flowchart for generating an image based on signal electrons emitted from a sample according to an embodiment of the disclosure.
FIG. 4 depicts a block diagram of an example computer system usable with systems and methods according to embodiments of the present disclosure.

### DETAILED DESCRIPTION

Charged beam particle systems that are used in electron microscopy provide high-resolution imaging by detecting signal electrons (e.g., backscattered electrons, secondary electrons, or the like) produced by the elastic scattering of a beam of electrons emitted from an electron emitter that interact with atoms of a sample. In one example, the electrons may be emitted from a cathode electrode that is heated by an electric current. The emitted electrons are attracted to an anode placed downstream of the cathode electrode, thus forming an electron beam directed to, and interacting with, the sample. The current of the signal electrons emitted from the electron beam interacting with the sample are measured by one or more electron detectors. This current can be used to generate a high-resolution image of the sample.

Some example charged beam particle systems can include scanning deflectors in the beam column that can generate a deflection field (e.g., electric or electromagnetic field) to deflect the electron beam as the electron beam travels through the beam column. However, the trajectory of the signal electrons emitted from the sample back into the beam column (e.g., toward the scanning deflectors) can be altered by this deflection field. This altered trajectory can lead to the signal electrons colliding with certain parts of the scanning deflector due to the geometry of the scanning deflector. For example, a lower scanning deflector may define an interior surface with a cylindrical shape. However, the signal electrons emitted from the sample at an angle to the electron beam may be obstructed by the interior surface of the lower scanning deflector before reaching the upper electron detector. This can lead to the upper electron detector only measuring a portion of the signal electrons. Specifically, as the lower scanning deflector is most likely to obstruct the outermost signal electrons, the generated image can include a vignetting effect, where the outer edges of the image appear different than the central portion of the image (e.g., the image of a homogenous specimen without topographic features has significant deviations of grey levels between the central portion and edges). This issue can be especially acute when trying to create an image with a large field of view (e.g., for specific workflows in semiconductor imaging).

Additionally, in conventional charged beam particle systems, one or more of the scanning deflectors may be too far from the objective lens. For example, the large distance between the lower scanning deflector (e.g., the scanning deflector in the beam column closest to the objective lens) and the objective lens can increase the likelihood that the electron beam collides with the deflectors due to the geometry of the electron beam and the deflectors. In particular, the larger distance between a center of deflection of the deflectors and the objective lens, the more that the deflection field of the deflectors would have to be excited to account for this distance. As the signal electrons define a signal beam having a conical shape with a virtual apex approximately at the sample, increasing the excitement of the deflection field would affect the shape of the signal beam such that the likelihood that a portion of the signal beam intersects with the deflectors increases (e.g., from a widening of the conical shape of the signal beam)..

The present disclosure addresses this issue by providing a charged beam particle system with a lower scanning deflector having a frustoconical shape. Specifically, one end of the lower scanning deflector oriented toward (e.g., facing) the upper electron detector can have a larger diameter than an opposite end of the lower scanning deflector oriented toward (e.g., facing) the backscatter electron detector and/or the sample such that the electrons passing through the lower scanning deflector may have a less likely chance of colliding with an interior surface of the lower scanning deflector. Additionally, the lower scanning deflector can be effectively moved closer to the objective lens to minimize the likelihood that the electron beam intersects with the lower scanning deflector. In this manner, more of the signal electrons may be received by the electron detectors and a vignetting-free large field of view image may be generated.

Although the remaining portions of the description will routinely reference scanning electron microscopes (SEM), it will be readily understood by the skilled artisan that the technology is not so limited. The present designs may be employed with other types of charged particle microscope, such as transmission electron microscope (TEM), scanning transmission electron microscope (STEM), dual beam systems including an ion beam source and an electron beam source, reflection electron microscopes (REM), circuit editing microscopes, or the like. Accordingly, the disclosure and claims are not to be considered limited to any particular example microscope discussed, but can be utilized broadly with any number of electron microscopes that may exhibit some or all of the electrical or chemical characteristics of the discussed examples.

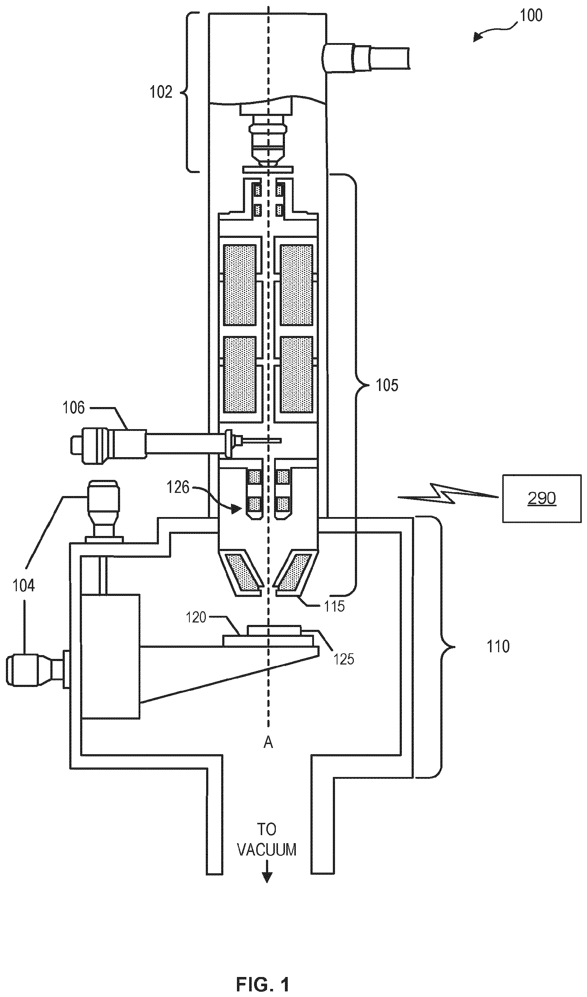

FIG. 1 is a schematic diagram of an example charged particle microscope 100, in accordance with some embodiments of the present disclosure. Example charged particle microscope 100 includes multiple sections including an electron source 102, a beam column 105, and a sample chamber 110. The electron source 102 includes high-voltage supply components, vacuum system components, and an electron emitter configured to generate a beam of electrons that is accelerated into the beam column 105. The beam column 105, in turn, can include electromagnetic lens elements and/or an aperture plate 106 that are configured to shape and form the beam of electrons from the electron source 102 into a substantially circular beam with a substantially uniform profile transverse to a beam axis A, and that conditions the beam to be focused onto a sample 125 by an objective lens 115.

The beam of electrons is typically characterized by a beam current and an accelerating voltage applied to generate the beam, among other criteria. The ranges of beam current and accelerating voltage can vary between instruments and are typically selected based on material properties of the sample or the type of analysis being conducted. Generally, however, beams of electrons are characterized by an energy from about 0.1 keV (e.g., for an accelerating voltage of 0.1 kV) to about 50 keV and a beam current from picoamperes to microamperes.

The sample chamber 110 and/or the beam column 105 can include multiple detectors for various signals, including but not limited to signal electrons generated by interaction of the beam of electrons and the sample, X-ray photons (e.g., EDAX), other photons (e.g., visible and/or IR cameras), and/or molecular species (e.g., TOF-SIMS). The sample chamber 110 can also include a sample holder 120 that can be operably coupled with a multi-axis translation/rotation control system 104 such that the sample 125 can be repositioned relative to the beam axis A, as an approach to surveying and/or imaging the sample 125. Further, the sample holder 120 can include apertures permitting transmission of electrons or other charged particles through the sample and the sample stage. In this way, one or more charged particle sensors of the present disclosure (e.g., electron detectors) can be disposed in the sample chamber 110 and/or in the beam column 105 and configured to detect signal electrons emanating from the sample.

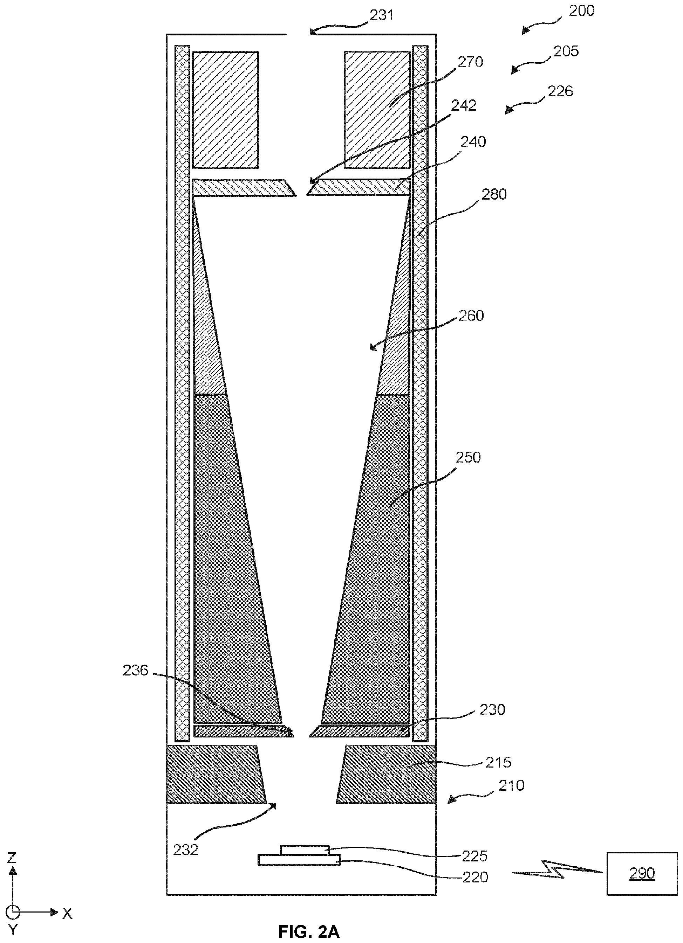

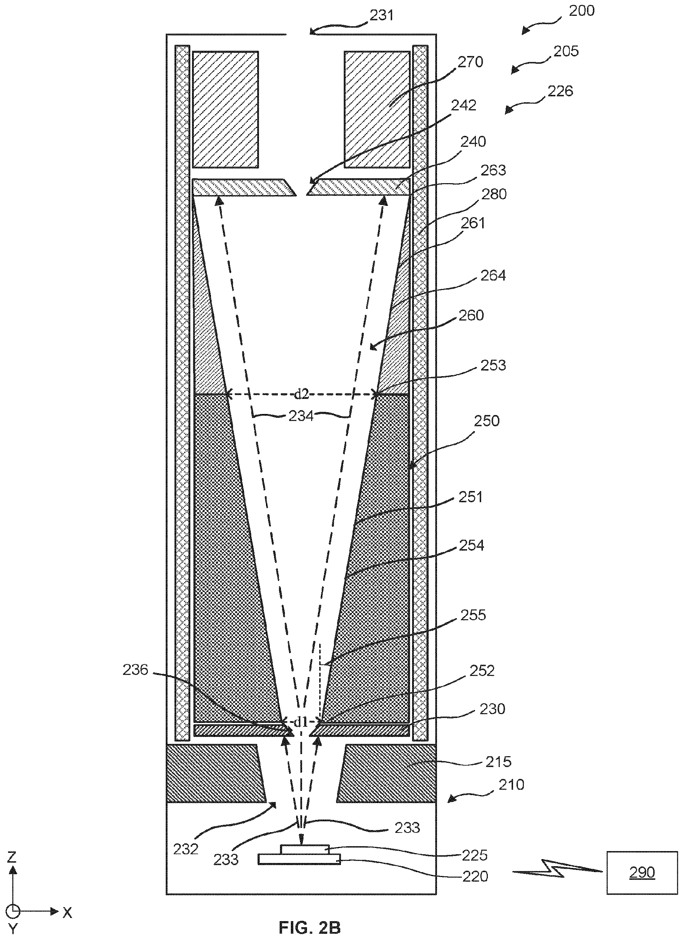

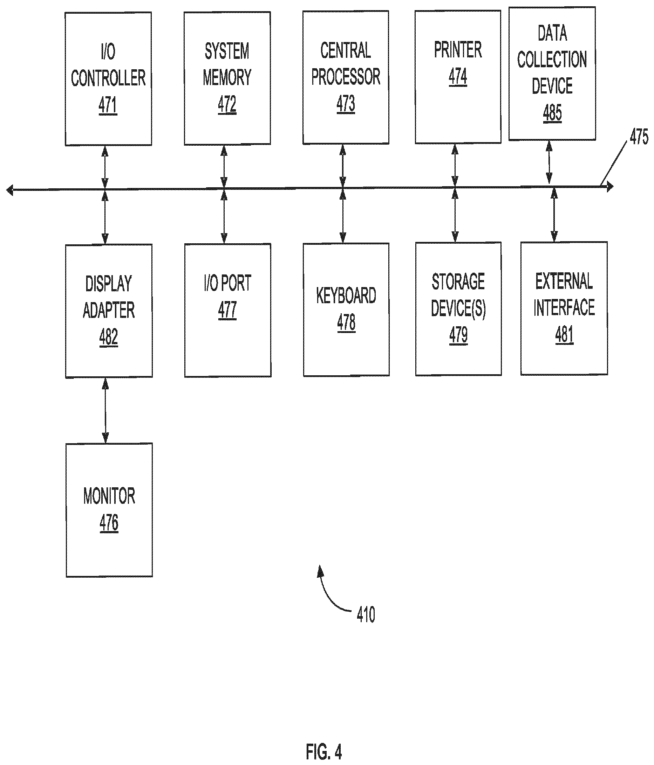

As discussed above, in conventional charged beam particle systems, one or more of the scanning deflectors may obstruct a trajectory of certain of the signal electrons (e.g., a portion of the secondary electrons). The beam column 105 may include an electron deflection system 126 that addresses this issue. In particular, the electron deflection system 126 can include one or more deflectors having a shape that minimizes the risk that the trajectory of the signal electrons is obstructed by the deflectors. Additionally, the electron deflection system 126 can enable one or more of electron detectors to be positioned closer to the objective lens 115. For example, FIGS. 2A and 2B depict an example charged beam particle system 200 and a computer system 290 (similar to the computer system 410, shown in FIG. 4) in communications with the charged beam particle system 200 to provide instructions to operate the charged beam particle system 200. For the sake of brevity, not all features of the charged beam particle system 200 are shown. It is understood that features ending in like reference numerals as features discussed above are similar, except as noted below. FIG. 2A shows the charged beam particle system 200 not in use and FIG. 2B shows the charged beam particle system 200 measuring signal electrons.

Turning to FIG. 2A, the beam column 205 may include an electron deflection system 226 that includes a first electron detector 230, a first scanning deflector 250, a second electron detector 240, and a second scanning deflector 270. An electron source may emit an electron beam into the beam column 205 through the column inlet 231, out of the beam column 205 through the beam outlet 232, through the objective lens 215, and onto the sample 225. The first electron detector 230 may be configured to measure a first current of a first set of electrons (e.g., backscattered electrons) emitted from the sample 225 after an electron beam interacts with the sample 225. The second electron detector 240 may be configured to measure a second current of a second set of electrons (e.g., secondary electrons) emitted from the sample 225 after the electron beam interacts with the sample 225. The second electron detector 240 may be upstream along the electron beam trajectory relative to the first electron detector 230. As such, the second electron detector 240 may be an upper electron detector and the first electron detector 230 may be a lower electron detector.

Either of the electron detectors 230, 240 may be an active detector (e.g., a semiconductor diode, an electron detector that uses scintillation principle, or the like) or passive detector (e.g., a conductive metal plate). In some embodiments, both the first electron detector 230 and second electron detector 240 may be the same type of detector (e.g., active or passive), however, in other embodiments, each of the first and second electron detectors may be different types of detectors.

Each of the scanning deflectors 250, 270 may generate a deflection field to direct and shape the electron beam toward the objective lens 215 and the sample 225. Specifically, the second scanning deflector 270 may generate a first deflection force to deflect one or more portions of an electron beam emitted from a column inlet 231 (e.g., from an electron source) to flow through an aperture 242 defined by the second electron detector 240. The first scanning deflector 250 may generate a second deflection force to further deflect one or more portions of the electron beam flowing from the second electron detector 240 to the objective lens 215 through an aperture 236 defined by the first electron detector 230. The second scanning deflector 270 may be upstream along the electron beam trajectory relative to the first scanning deflector 250. As such, the second scanning deflector 270 may be an upper scanning deflector and the first scanning deflector 250 may be a lower scanning deflector.

As discussed above, in conventional charged beam particle systems, at least some of the signal electrons emitted from the sample may be obstructed by the first scanning deflector (e.g., the lower scanning deflector) due, at least in part, to the deflection field generated by the lower scanning deflector such that only a portion of the signal electrons are measured by the upper electron detector. The shape of the first scanning deflector 250 of the present disclosure addresses this issue. Turning to FIG. 2B, after the electron beam interacts with the sample 225, first electrons 233 (e.g., backscattered electrons) are emitted from the sample 225 to be measured by the first electron detector 230 and second electrons 234 (e.g., secondary electrons) are emitted from the sample 225 to be measured by the second electron detector 240. The first scanning deflector 250 defines a deflector interior surface 251 having a frustoconical shape such that a trajectory of the second electrons 234 are not obstructed by the deflector interior surface 251. The first scanning deflector 250 may include a first end 252 oriented (e.g., facing) towards the first electron detector 230. The first end 252 may have a first diameter d1 lesser than a second diameter d2 of a second end 253 of the scanning deflector 250 oriented toward (e.g., facing) the second electron detector 240. The diameters d1, d2 may be the major diameter of the ends 252, 253.

The deflector interior surface 251 may have a deflector slope 254 that is substantially linear. However, in other embodiments, the interior surface may have other shapes, such as having a convex or concave shape, a stepwise shape, or having various angled or curved surfaces. Additionally, the deflector interior surface 251 may have an angle 255 with respect to a Z-axis (e.g., an axis parallel to the electron beam axis). In some embodiments, the angle 255 may correspond to a major dimension of the second electron detector 240 and distance the second electron detector 240 from the first end 252. For example, the angle 255 may be an angle of a substantially straight line (as shown in the cross-sectional view of FIG. 2B) from the first end 252 to the major diameter of the second electron 240. In one example, the angle 255 may be between about 10° and 45°, such as between about 15° and 40°, between about 20° and 35°, or between about 25° and 30°.

As the deflector interior surface 251 has a frustoconical shape from a first end 252 having a first diameter d1 to a second end 253 having a second diameter d2, the second electrons 234 may flow from the column outlet 232 at a transverse angle to the Z-axis to the second electron detector 240 without being obstructed by the deflector interior surface 251. In this manner, more of the second electrons 234 may be measured by the second electron detector 240 and a more detailed image of the sample 225 (e.g., without the vignetting effect caused by conventional systems) may be generated.

Also as discussed above, because the scanning deflectors in conventional charged beam particle systems are far away from the objective lens, the likelihood that the signal beam may be obstructed by the deflectors may increase. The first scanning deflector 250 addresses this because the shape of the deflector interior surface 251 changes a center of deflection of the first scanning deflector 250 from the objective lens 215. In particular, the center of deflection of the first scanning deflector 250 corresponds to the strength of the deflection field generated by the first scanning deflector 250 and the strength of the deflection field generated by the first scanning deflector 250 corresponds with a diameter of the deflector interior surface 251. As such, the deflection field generated by the first scanning deflector 250 is strongest at the first end 252, therefore moving the center of deflection of the first scanning deflector 250 closer to the objective lens 215. Moving the center of deflection of the first scanning deflector 250 closer to the objective lens 215 can reduce the required excitement of the deflection field of the first scanning deflector 250, thus minimizing altering (e.g., widening) the shape of the signal beam defined by the second electrons 234. In turn, this decreases the risk that the second electrons 234 collide with the first scanning deflector 250 (or the drift section interior surface 261).

The vignetting effects can also be further decreased by positioning the first electron detector 240 closer to the objective lens 215 than in conventional charged beam particle systems. In conventional charged beam particle systems, the upper electron detector may be positioned upstream of the second scanning deflector (e.g., the upper scanning deflector) such that the upper scanning deflector is between the upper electron detector and the objective lens. As the upper electron detector is positioned further away, and the upper scanning deflector is positioned between the upper electron detector and the objective lens, the trajectory of the secondary electrons may have a higher chance of being altered and obstructed (e.g., by the upper scanning deflector, or other objects between the upper electron detector and the objective lens) before reaching the upper electron detector. Accordingly, the position and orientation of the upper electron detector in the beam column of conventional charged beam particle systems can result in lower quality images of the sample, such as images with a vignetting effect.

These issues are addressed in the charged beam particle system 200 by positioning the second electron detector 240 between the second scanning deflector 270 and the objective lens 215. In this manner, the second electron detector 240 can be positioned closer to the objective lens 215 while also minimizing objects that may impede the trajectory of second electrons 234. This can result in more second electrons 234 being measured by the second electron detector 240 and, therefore, a clearer image being generated.

It may be beneficial to provide space (e.g., a drift section 260) between the second detector 240 and the second end 253 of the first scanning deflector 250 to further minimize image distortion effects. This drift section 260 may account for the altered trajectory of the second electrons 234 from the deflection field generated by the first scanning deflector 250 such that, if the second electron detector 240 were closer to the first scanning deflector 250 (e.g., with no drift section 260, such that the second electron detector 240 is positioned against the second end 253), the generated image may have more vignetting effects due to the altered trajectory of the second electrons 234 impacting other features of the beam column 205 before reaching the second electron detector 240. However, the drift section 260 between the second scanning detector 240 and the first scanning deflector 250 may account for this change in trajectory and allow for more of the second electrons 234 the space to be received by the second electron detector 240. However, in other embodiments, there may be no drift section and, instead, the second electron detector may be coupled against the second end of the first scanning deflector. In some embodiments, the drift section 260 may be defined by a housing of the beam column 205. However, in other embodiments, the drift section may be defined by a separate component of the beam column.

The drift section 260 may include a drift section interior surface 261 having a drift section slope 264 that is similar in value to the deflector slope 254. For example, the drift section slope 264 and the deflector slope 254 may have about 70% the same value, about 80% the same value, about 90% the same value, or about completely the same value. In one example, the drift section interior surface 261 may have a substantially similar angle from a Z-axis as the deflector slope 254 (e.g., the angle 255). For example, the drift section slope 264 and the deflector slope 254 may have about 70% the same angle, about 80% the same angle, about 90% the same angle, or about completely the same angle. As such, the drift section interior surface 261 may define a frustoconical shape. The shape of the drift section interior surface 261 may allow the second electrons 234 to travel through the drift section 260 from the first scanning deflector 250 while minimizing the risk that the trajectory of the second electrons 234 that are traveling at a transverse angle to the Z-axis are obstructed by other components (e.g., a more cylindrical drift interior surface). The drift section interior surface 261 may have a drift section slope 264 that is substantially linear from the second end 253 to a third end 263 of the drift section interior surface 261. However, in other embodiments, the drift section interior surface may have other shapes, such as having a convex or concave shape, a stepwise shape, or having various angled or curved surfaces. In yet other embodiments, the drift section interior surface and the deflector interior surface may each have different shapes. For example, the drift section interior surface may have a conical shape with a diameter corresponding to a major dimension of the second electron detector while the deflector interior surface has a frustoconical shape.

The second electron detector 240 may have a dimension along the X-Y plane that corresponds to a diameter of the third end 263. For example, the diameter of the second electron detector 240 and the third end 263 may be about 70% the same value, about 80% the same value, about 90% the same value, or about completely the same value. In this manner, the second electron detector 240 may more likely measure all the second electrons 234 traveling through the drift section 260. However, in other embodiments, the diameters of the second electron detector and the third end of the drift interior surface may be different. For example, the diameter of the second electron detector may be greater than the diameter of the third end of the drift interior surface or vice versa.

The electron detectors 230, 240 can be used with a variety of other components. For example, the electron detectors 230, 240 can be used with a booster tube 280 in the beam column 205 or a sample bias (e.g., a negative sample bias or the like) in the sample chamber 210. The booster tube 280 may generate an electromagnetic field to increase the kinetic energy of electrons in the beam column 205. The sample holder 220 may be electrically biased to generate an electromagnetic field around the sample holder 220 and accelerate the signal electrons from the sample 225 to the beam column 205. In some embodiments, the beam column 205 may house the booster tube 280. The booster tube 280 may at least partially surround one or more components of the beam column 205. For example, the booster tube 280 may at least partially surround the first electron detector 230, the second electron detector 240, the first scanning deflector 250, the drift section 260, and the second scanning deflector 270, such that the first electron detector 230, the second electron detector 240, the first scanning deflector 250, the drift section 260, and the second scanning deflector 270 are positioned in the booster tube 280. In other embodiments, the scanning deflectors may be positioned outside or around the booster tube (e.g., surrounding a length of the booster tube). In some embodiments, the charged beam particle system may have only one of the booster tube or the sample bias. In yet other embodiments, the charged beam particle system may not have a booster tube or sample bias.

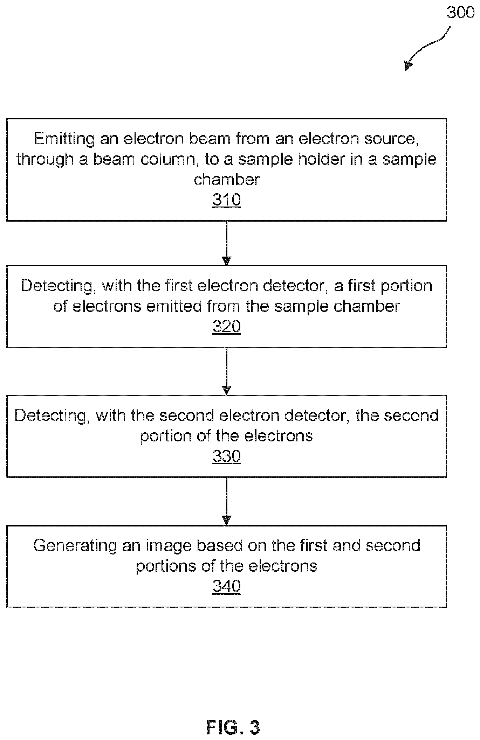

FIG. 3 depicts an example flowchart showing a process 300 for generating an image based on signal electrons emitted from a sample. It is understood that features ending in like reference numerals as features discussed above are similar, except as noted below. Unless step specified otherwise, the flowchart in FIG. 3 will be described with reference to the charged beam particle system 200 shown in FIGS. 2A and 2B. The below operation of the components of the charged beam particle system 200 can be performed by the computer system 290.

Block 310 may include emitting an electron beam from an electron source, through a beam column 205, to a sample holder 220 in a sample chamber 210. The beam column 205 may include a first electron detector 230, a second electron detector 240, and a first scanning deflector 250 positioned between the first electron detector 230. The first scanning deflector 250 may include a deflector interior surface 251 including a frustoconical shape. For example, the electron source may emit the electron beam from the column inlet 231 through the components of the beam column 205, the column outlet 232, the objective lens 215, and toward the sample holder 220 to interact with the sample 225.

Block 320 may include detecting, with the first electron detector 230, a first portion of electrons emitted from the sample chamber 210. For example, the first electron detector 230 may include detecting the backscattered electrons emitted from the sample 225 after the electron beam interacts with the sample 225. The first electron detector 230 may measure a current of the backscattered electrons.

Block 330 may include detecting, with the second electron detector 240, the second portion of the electrons. For example, the second electron detector 240 may measure a current of the secondary electrons.

Block 340 may include generating an image based on the first and second portions of the electrons. For example, an image may be generated based on the measurements of the backscattered electrons detected by the first electron detector 230 and the secondary electrons detected by the second electron detector 240.

Any of the computer systems mentioned herein (e.g., the computer system 290) may utilize any suitable number of subsystems. Examples of such subsystems are shown in FIG. 4 in computer system 410. In some embodiments, a computer system includes a single computer apparatus, where the subsystems can be the components of the computer apparatus. In other embodiments, a computer system can include multiple computer apparatuses, each being a subsystem, with internal components. A computer system can include desktop and laptop computers, tablets, mobile phones and other mobile devices.

The subsystems shown in FIG. 4 are interconnected via a system bus 475. Additional subsystems such as a printer 474, keyboard 478, storage device(s) 479, monitor 476 (e.g., a display screen, such as an LED), which is coupled to display adapter 482, and others are shown. Peripherals and input/output (I/O) devices, which couple to I/O controller 471, can be connected to the computer system by any number of means known in the art such as input/output (I/O) port 477 (e.g., USB, FireWire^{®}). For example, I/O port 477 or external interface 481 (e.g., Ethernet, Wi-Fi, etc.) can be used to connect computer system 410 to a wide area network such as the Internet, a mouse input device, or a scanner. The interconnection via system bus 475 allows the central processor 473 to communicate with each subsystem and to control the execution of a plurality of instructions from system memory 472 or the storage device(s) 479 (e.g., a fixed disk, such as a hard drive, or optical disk), as well as the exchange of information between subsystems. The system memory 472 and/or the storage device(s) 479 may embody a computer readable medium. Another subsystem is a data collection device 485, such as a camera, microphone, accelerometer, and the like. Any of the data mentioned herein can be output from one component to another component and can be output to the user.

A computer system can include a plurality of the same components or subsystems, e.g., connected together by external interface 481, by an internal interface, or via removable storage devices that can be connected and removed from one component to another component. In some embodiments, computer systems, subsystem, or apparatuses can communicate over a network. In such instances, one computer can be considered a client and another computer a server, where each can be part of a same computer system. A client and a server can each include multiple systems, subsystems, or components.

Aspects of embodiments can be implemented in the form of control logic using hardware circuitry (e.g., an application specific integrated circuit or field programmable gate array) and/or using computer software stored in a memory with a generally programmable processor in a modular or integrated manner, and thus a processor can include memory storing software instructions that configure hardware circuitry, as well as an FPGA with configuration instructions or an ASIC. As used herein, a processor can include a single-core processor, multicore processor on a same integrated chip, or multiple processing units on a single circuit board or networked, as well as dedicated hardware. Based on the disclosure and teachings provided herein, a person of ordinary skill in the art will know and appreciate other ways and/or methods to implement embodiments of the present disclosure using hardware and a combination of hardware and software.

Any of the software components or functions described in this application, such as process 300, may be implemented as software code to be executed by a processor using any suitable computer language such as, for example, Java, C, C++, C#, Objective-C, Swift, or scripting language such as Perl or Python using, for example, conventional or object-oriented techniques. The software code may be stored as a series of instructions or commands on a computer readable medium for storage and/or transmission. A suitable non-transitory computer readable medium can include random access memory (RAM), a read only memory (ROM), a magnetic medium such as a hard-drive or a floppy disk, or an optical medium such as a compact disk (CD) or DVD (digital versatile disk) or Blu-ray disk, flash memory, and the like. The computer readable medium may be any combination of such devices. In addition, the order of operations may be re-arranged. A process can be terminated when its operations are completed, but could have additional steps not included in a figure. A process may correspond to a method, a function, a procedure, a subroutine, a subprogram, etc. When a process corresponds to a function, its termination may correspond to a return of the function to the calling function or the main function.

Such programs may also be encoded and transmitted using carrier signals adapted for transmission via wired, optical, and/or wireless networks conforming to a variety of protocols, including the Internet. As such, a computer readable medium may be created using a data signal encoded with such programs. Computer readable media encoded with the program code may be packaged with a compatible device or provided separately from other devices (e.g., via Internet download). Any such computer readable medium may reside on or within a single computer product (e.g., a hard drive, a CD, or an entire computer system), and may be present on or within different computer products within a system or network. A computer system may include a monitor, printer, or other suitable display for providing any of the results mentioned herein to a user.

Any of the methods described herein may be totally or partially performed with a computer system including one or more processors, which can be configured to perform the steps. Any operations performed with a processor (e.g., aligning, determining, comparing, computing, calculating) may be performed in real-time. The term *"real-time"* may refer to computing operations or processes that are completed within a certain time constraint. The time constraint may be 1 minute, 1 hour, 1 day, or 7 days. Thus, embodiments can be directed to computer systems configured to perform the steps of any of the methods described herein, potentially with different components performing a respective step or a respective group of steps. Although presented as numbered steps, steps of methods herein can be performed at a same time or at different times or in a different order. Additionally, portions of these steps may be used with portions of other steps from other methods. Also, all or portions of a step may be optional. Additionally, any of the steps of any of the methods can be performed with modules, units, circuits, or other means of a system for performing these steps.

In the foregoing specification, embodiments of the disclosure have been described with reference to numerous specific details that can vary from implementation to implementation. The specification and drawings are, accordingly, to be regarded in an illustrative rather than a restrictive sense. The sole and exclusive indicator of the scope of the disclosure, and what is intended by the applicants to be the scope of the disclosure, is the literal and equivalent scope of the set of claims that issue from this application, in the specific form in which such claims issue, including any subsequent correction. The specific details of particular embodiments can be combined in any suitable manner without departing from the spirit and scope of embodiments of the disclosure.

Additionally, spatially relative terms, such as "bottom" or "top" and the like can be used to describe an element and/or feature's relationship to another element(s) and/or feature(s) as, for example, illustrated in the figures. It will be understood that the spatially relative terms are intended to encompass different orientations of the device in use and/or operation in addition to the orientation depicted in the figures. For example, if the device in the figures is turned over, elements described as a "bottom" surface can then be oriented "above" other elements or features. The device can be otherwise oriented (e.g., rotated 90 degrees or at other orientations) and the spatially relative descriptors used herein interpreted accordingly.

Terms "and," "or," and "an/or," as used herein, may include a variety of meanings that also is expected to depend at least in part upon the context in which such terms are used. Typically, "or" if used to associate a list, such as A, B, or C, is intended to mean A, B, and C, here used in the inclusive sense, as well as A, B, or C, here used in the exclusive sense. In addition, the term "one or more" as used herein may be used to describe any feature, structure, or characteristic in the singular or may be used to describe some combination of features, structures, or characteristics. However, it should be noted that this is merely an illustrative example and claimed subject matter is not limited to this example. Furthermore, the term "at least one of" if used to associate a list, such as A, B, or C, can be interpreted to mean any combination of A, B, and/or C, such as A, B, C, AB, AC, BC, AA, AAB, ABC, AABBCCC, etc.

Reference throughout this specification to "one example," "an example," "certain examples," or "exemplary implementation" means that a particular feature, structure, or characteristic described in connection with the feature and/or example may be included in at least one feature and/or example of claimed subject matter. Thus, the appearances of the phrase "in one example," "an example," "in certain examples," "in certain implementations," or other like phrases in various places throughout this specification are not necessarily all referring to the same feature, example, and/or limitation. Furthermore, the particular features, structures, or characteristics may be combined in one or more examples and/or features.

In some implementations, operations or processing may involve physical manipulation of physical quantities. Typically, although not necessarily, such quantities may take the form of electrical or magnetic signals capable of being stored, transferred, combined, compared, or otherwise manipulated. It has proven convenient at times, principally for reasons of common usage, to refer to such signals as bits, data, values, elements, symbols, characters, terms, numbers, numerals, or the like. It should be understood, however, that all of these or similar terms are to be associated with appropriate physical quantities and are merely convenient labels. Unless specifically stated otherwise, as apparent from the discussion herein, it is appreciated that throughout this specification discussions utilizing terms such as "processing," "computing," "calculating," "determining," or the like refer to actions or processes of a specific apparatus, such as a special purpose computer, special purpose computing apparatus or a similar special purpose electronic computing device. In the context of this specification, therefore, a special purpose computer or a similar special purpose electronic computing device is capable of manipulating or transforming signals, typically represented as physical electronic or magnetic quantities within memories, registers, or other information storage devices, transmission devices, or display devices of the special purpose computer or similar special purpose electronic computing device.

In the preceding detailed description, numerous specific details have been set forth to provide a thorough understanding of claimed subject matter. However, it will be understood by those skilled in the art that claimed subject matter may be practiced without these specific details. In other instances, methods and apparatuses that would be known by one of ordinary skill have not been described in detail so as not to obscure claimed subject matter. Therefore, it is intended that claimed subject matter not be limited to the particular examples disclosed, but that such claimed subject matter may also include all aspects falling within the scope of appended claims, and equivalents thereof.

## Claims

1. A charged beam particle system, comprising:
a first electron detector;
a second electron detector; and
a first scanning deflector positioned between the first electron detector and the second electron detector, wherein the first scanning deflector includes a deflector interior surface including a frustoconical shape.

2. The charged beam particle system of claim 1, further comprising a second scanning deflector, wherein the second electron detector is positioned between the second scanning deflector and the first scanning deflector.

3. The charged beam particle system of claim 2, wherein:
the first scanning deflector includes a first end oriented toward the first electron detector and a second end oriented toward the second electron detector; and
the first end has a first diameter and the second end has a second diameter different than the first diameter.

4. The charged beam particle system of claim 3, wherein the second diameter is greater than the first diameter.

5. The charged beam particle system of claim 3,
further comprising a drift section extending from the second end to the second electron detector,
wherein:
the deflector interior surface defines a first slope from the first end to the second end; and
the drift section includes a drift interior surface defining a second slope from the second end to the second electron detector that is substantially the same as the first slope.

6. The charged beam particle system of any preceding claim, further comprising a beam column, wherein the first electron detector, the second electron detector, and the first scanning deflector are in the beam column.

7. The charged beam particle system of claim 6, wherein:
the beam column includes a booster tube; and
the first scanning deflector, the first electron detector, and the second electron detector are positioned in, or around a length, of the booster tube.

8. The charged beam particle system of any preceding claim, further comprising a sample chamber including a sample holder having a sample bias.

9. The charged beam particle system of any preceding claim, wherein the first electron detector is a backscatter electron detector configured to measure a first current of backscatter electrons and the second electron detector is a secondary electron detector configured to measure a second current of secondary electrons.

10. A method of using a charged beam particle system comprising:
emitting an electron beam from an electron source, through a beam column, to a sample holder in a sample chamber, wherein the beam column includes:
a first electron detector;
a second electron detector; and
a first scanning deflector positioned between the first electron detector and the second electron detector, wherein the first scanning deflector includes a deflector interior surface including a frustoconical shape;
detecting, with the first electron detector, a first portion of signal electrons emitted from the sample chamber;
detecting, with the second electron detector, a second portion of the signal electrons emitted from the sample chamber; and
generating an image based on the first and second portions of the electrons.

11. The method of claim 10, wherein the first electron detector is a backscatter electron detector configured to measure a first current of backscatter electrons and the second electron detector is a secondary electron detector configured to measure a second current of secondary electrons.

12. The method of claim 10, wherein:
the beam column includes a second scanning deflector; and
the second electron detector is positioned between the second scanning deflector and the first scanning deflector.

13. The method of any one of claims 10-12, wherein:
the first scanning deflector includes a first end oriented toward the first electron detector and a second end oriented toward the second electron detector; and
the first end has a first diameter and the second end has a second diameter different than the first diameter.

14. The method of any one of claims 10-13,
further comprising a drift section extending from the second end to the second electron detector,
wherein:
the deflector interior surface defines a first slope from the first end to the second end; and
the drift section includes a drift interior surface defining a second slope from the second end to the second electron detector that is substantially the same as the first slope.

15. The method of any one of claims 10-14, further comprising a sample chamber including a sample holder having a sample bias.
